Europäisches Patentamt

European Patent Office

Office européen des brevets

(11) Publication number: **0 259 217**
**A2**

(12) **EUROPEAN PATENT APPLICATION**

(21) Application number: **87401919.3**

(22) Date of filing: **21.08.87**

(51) Int. Cl.⁴: **H 03 D 7/00**

(30) Priority: **21.08.86 US 898552**

(43) Date of publication of application:
**09.03.88 Bulletin 88/10**

(84) Designated Contracting States:
**DE FR GB IT NL SE**

(71) Applicant: **GRUMMAN AEROSPACE CORPORATION**
**South Oyster Bay Road**
**Bethpage, NY 11714 (US)**

(72) Inventor: **Clarius, M. Georges A.**
**9 Sheryl Crescent**
**Smithtown New York 11787 (US)**

(74) Representative: **Armengaud Ainé, Alain**
**Cabinet ARMENGAUD AINE 3 Avenue Bugeaud**
**F-75116 Paris (FR)**

(54) DC offset network for RF signals.

(57) A low power level RF signal is processed by a network which adds a DC offset level thereby effectively increasing the power level of the RF signal. External switching circuits connected to the offset signal will be more responsive to the signal due to the effective power elevation.

FIG. 1

EP 0 259 217 A2

**Description**

## DC OFFSET NETWORK FOR RF SIGNALS

### FIELD OF THE INVENTION

The present invention relates to biasing circuits, and more particularly to a network for adding a DC offset to an RF signal.

### BACKGROUND OF THE INVENTION

In a number of applications involving RF signals, the signals are provided at very low power levels which are incapable of actuating signal processing components, such as diodes. Previously, power-boosting active circuits have been considered for the task of increasing the power levels of such RF signals. However, the utilization of such power boosting circuits has definite. disadvantages, including signal distortion, reliability problems, and significant expense.

Accordingly, it would be highly desirable to effect a power shift of such RF signals using a relatively simple, reliable and inexpensive circuit.

### BRIEF DESCRIPTION OF THE PRESENT INVENTION

The present invention achieves the desired goals by introducing a DC offset to an RF signal so that the effective power level of the RF signal is significant enough to affect switching of signal processing components, such as diodes, which would otherwise be insensitive to normally low-powered RF signals.

In the present invention, a DC offset is introduced through a resistor which is coupled to LC components that isolate the source of the RF signal and the source of the DC offset so that they may operate separately near ideal conditions. The present invention enables a DC offset network to be built from existing subassemblies of LC components with inexpensive and non-time-consuming modification to achieve the desired goals.

The above-mentioned objects and advantages of the present invention will be more clearly understood when considered in conjunction with the accompanying drawings, in which:

### BRIEF DESCRIPTION OF THE FIGURES

FIG. 1 is a schematic diagram of the present DC offset network for RF signals;

FIG. 2A is a plot of a typical RF signal presented at port 1 of the present inventive network;

FIG. 2B is a plot of a DC voltage introduced at port 3 of the inventive network;

FIG. 2C is a plot of the superposition of the signals indicated in FIGS. 2A and 2B, which demonstrates the DC offset to the signal of FIG. 2A;

FIG. 3 is a schematic diagram of a double-balanced mixer which is aided by a DC offset RF input.

### DETAILED DESCRIPTION OF THE INVENTION

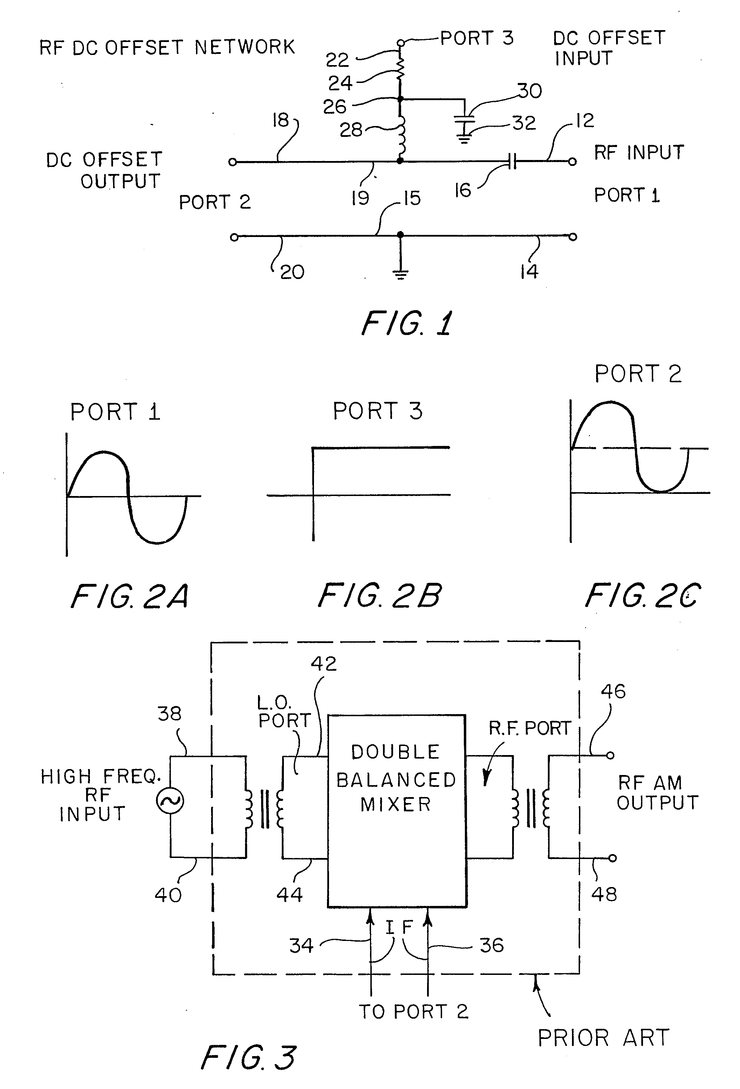

FIG. 1 is a schematic diagram of a DC offset network for RF signals and is generally indicated by reference numeral 10. An RF signal, typically a CW signal in the MHz range is presented from a source (not shown) to the RF input terminals 12 and 14 of port 1. Terminal 14 is preferably grounded and terminates at an output terminal 20. Terminal 12 is serially connected to capacitor 16 which in turn is connected to output terminal 18 via line 19. Terminals 18 and 20 represent the desired DC offset RF output at indicated port 2, as will be presently explained.

Port 3 is defined at terminal 22 of the network which is serially connected to junction 26 via resistor 24. Junction 26 is connected in parallel with capacitor 30, grounded at 32 and parallel connected inductor 28 which terminates in line 19.

During successful operation of the present invention, an RF signal, such as shown in FIG. 2A, is introduced at port 1. At the same time, a DC voltage, as shown in FIG. 2B, is introduced at port 3 (terminal 22). Capacitor 16 serves to block any DC component from being fed back to an RF source connected to port 1. The combination of inductor 28 and capacitor 30 forms a low-pass filter for blocking RF energy from entering the DC source connected to port 3. By properly selecting resistor 24, current may be limited to a desirable level at the output (port 2). The resistor 24 also serves to attenuate RF energy, thereby isolating a DC source which may be connected to port 3.

The successful operation of the present invention results in a DC level shift of the RF input signal at port 1 by an offset determined by the voltage at port 3 and the value of resistor 24. The shifted RF signal is illustrated in FIG. 2C.

For extremely low-power RF signals such as intended in FIG. 3, there may be insufficient power to switch succeeding signal processing circuits. However, by adding a DC offset to the original low-power RF signal, such as indicated in FIG. 2C, the effective elevated power levels of the RF signal can be made to cause switching action in signal processing circuits.

Capacitors 16 and 30 should be of equal value to offer the least impedance to the RF input signal at port 1. A further design consideration is to choose inductor 28 to have an inductive reactance equal to 2 1/5 - 3 times the impedance of resistor 24. A still further design characteristic is to select the impedances at the RF input (port 1) and the RF offset output (port 2) to be 50 ohms, compatible with other RF devices. Of course, these design characteristics may be altered for different types of applications for the inventive circuit.

A typical application of the present invention is in combination with a conventional double-balanced mixer, the combination being the subject matter of my co-pending application assigned to the present assignee. In the combination invention, the RF DC offset network 10 of the present invention generates an desired RF signal at input terminals 38 and 40 of a double-balanced mixer 38. A very high frequency RF input is presented at input terminals 38 and 40, the frequency thereat typically being in the GHz range. The transformed input is then fed to mixer input terminals 42 and 44 where the signal thereat is mixed with the IF signal at terminals 34 and 36, the IF signal being generated at port 2 of the present offset network. At the output terminals 46 and 48 of the mixer is an amplitude-modulated signal comprising modulation of the high frequency input by the IF signal. In this application of the present invention, the diodes which actually comprise the balanced mixer 38 would be unresponsive to the IF signal at terminals 34 and 36 unless the signal had sufficient power. The present invention achieves that sufficient power to switch the diodes of the mixer by lending a DC offset to the relatively low RF input which will form the IF input to the mixer, thus providing the desired RF signal output at terminals 46 and 48.

Although the present network of FIG. 1 is explained in a particular application in connection with a double-balanced mixer, it is to be appreciated that it has wide applicability as a means for boosting the effective RF power of a signal which is originally low powered.

It should be understood that the invention is not limited to the exact details of construction shown and described herein, for obvious modifications will occur to persons skilled in the art.

## Claims

1. An electrical network for adding a DC offset to a relatively low power RF input signal, the network comprising:
   a first port for receiving the low power RF input signal;
   a second port for receiving a preselected DC input signal;
   a junction for superposing the DC signal on the RF signal for offsetting the RF signal by a preselected DC level; and
   a third port connected to the junction for making the offset RF signal available as an output of the network.

2. The structure set forth in claim 1 together with capacitive means connected between the first and second ports for blocking the DC signal from the first port.

3. The structure set forth in claim 1 together with filter means connected between the first and second ports for blocking the RF signal from the third port.

4. The structure set forth in claim 1, 2 or 3, together with resistive means connected in circuit with the second port for limiting DC current into the network and further isolating the second port from the RF input signal.

5. An electrical network for adding a DC offset to a relatively low power RF input signal, the network comprising:

a first port for receiving the low power RF input signal;
a second port for receiving a preselected DC input signal;
a first capacitor connected in-line with the first port for blocking the DC signal from the first port;
an inductor and a second capacitor connected in circuit with the second port for blocking passage of the RF signal to the second port;
a resistor serially connected with the second port for limiting DC current through the port and for further isolating the second port from the RF signal; and
a third port connected to a junction defined between the inductor and the first capacitor for making available the RF signal offset by a DC level from the second port.

0259217

RF DC OFFSET NETWORK

PORT 3   DC OFFSET INPUT

22
24
30
26
28
32
18
12
DC OFFSET OUTPUT   RF INPUT
PORT 2   PORT 1
19   15   16
20   14

FIG. 1

PORT 1

FIG. 2A

PORT 3

FIG. 2B

PORT 2

FIG. 2C

42
L.O. PORT   R.F. PORT   46
38
HIGH FREQ. RF INPUT   DOUBLE BALANCED MIXER   RF AM OUTPUT
40   44   48
34   I F   36
TO PORT 2
PRIOR ART

FIG. 3